(19) Europäisches Patentamt

European Patent Office

Office européen des brevets

(11) **EP 3 297 044 A1**

(12) **EUROPEAN PATENT APPLICATION**

(43) Date of publication:
**21.03.2018 Bulletin 2018/12**

(21) Application number: **16189542.0**

(22) Date of filing: **19.09.2016**

(51) Int Cl.:
*H01L 33/20* (2010.01)    *H01L 33/46* (2010.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Shepherd, Nick**
**6900 Bregenz (AT)**

(72) Inventor: **Shepherd, Nick**
**6900 Bregenz (AT)**

(74) Representative: **Wittmann, Günther**
**Patentanwaltskanzlei Wittmann**
**Frans-Hals-Straße 31**
**81479 München (DE)**

(54) **IMPROVED LED EMITTER, LED EMITTER ARRAY AND METHOD FOR MANUFACTURING THE SAME**

(57)    The invention discloses a light emitter, comprising:
- a transparent semiconductor substrate;
- an epitaxial layer of a light emitting diode formed on a first side of the transparent semiconductor device; and
- a convex optical structure formed on the second side of the substrate opposite to the light emitting diode, wherein the convex optical structure is adapted to reflect and collimate light passing through the substrate; wherein light emitted from the light emitting diode passes through the substrate, is reflected by the convex optical structure, passes again through the transparent optical substrate and is emitted by the first side of the substrate.

The convex optical structure may be fabricated by laser ablation.

Fig. 17

EP 3 297 044 A1

## Description

The present invention relates to an improved LED emitter, an improved LED emitter array and a method for manufacturing the same. The LED emitter array may be comprised by an apparatus for direct substrate lithography and/or a display

### State of the Art

LED devices typically have large area electrodes to maximise the light generation over the surface of the substrate. When driving an electrical current through the LED, each point on the surface generates light that is emitted in all directions. When each point generates light simultaneously this is a broad source as opposed to a point source that is typically considered in imaging optical design. With a broad source, using external optics to converge the emitted light to a focus cannot be done effectively and this results in a broad spot, not a point focus.

A compromise situation occurs where the dimensions of the broad source are reduced, with the effect that the emitting area is closer to a point source. Typically, the current is also reduced by a corresponding amount to maintain a constant current density. As the dimensions decrease, a consequence is that the amount of light that is generated also decreases, and the optical flux, becomes very small. In the simplest case, this optical flux is insufficient to be useful for most applications. . Thus increasing the optical efficiency of the system is important when defining the dimensions and electrical characteristics of a small emitter, allowing it to operate at more typical current densities.

A second challenge is to generate a focused beam from the LED source using external optics. The large difference in refractive indices between the substrate and air present a significant barrier to efficiently extract the light from the LED substrate. Where the light is transmitted through a polished parallel sided substrate, only ~ 7% of the generated light escapes without internal reflection. The escaped light is also diverging and when transmitted through some external optics to focus the light, further losses occur that could be greater than >50%. The overall result of the combined losses is that only a few percentage of the light generated in the LED can be brought to a focus. Typically, this is insufficient to be useful for most industrial applications.

LED devices are an electrical diode with two contacts. When a voltage is applied across the diode, light is emitted from the diode. The amount of light emitted is controlled by the current flowing across the diode. It is typical in LED applications to control the current and allow the voltage necessary to drive this current to vary. The so called constant current control.

In a GaN semiconductor LED device, the negative n-contact is typically the semiconductor substrate (in other semiconductor materials, the substrate could be the p-contact.). In its simplest form, a vertical diode can be fabricated where the electrical contacts are on opposite sides or the substrate. Alternatively, the LED can be fabricated in a lateral design and the n-contacts exposed in a window through the p-semiconductor layer on the same side as the p contact. When the diodes are fabricated as an array, the n-contacts are still common, only the p-contact is unique to the individual diode. This allows more conventional packaging approaches.

For the assembly of the LEDs, e.g. packaging, it is normal that the electrical pin-outs are both located on one substrate. This requires that at least one of the electrical contacts to the diode is wire bonded to accommodate the step height. Alternatively, when the LED is fabricated in a lateral design the diode can also be mounted as a surface mount component by soldering, ball bonding or similar technique. In some cases, even when the contacts are on the same side of the substrate, both are wire bonded to the package.

Both these mounting methods assume at least one unique electrical contacts for each diode fabricated. Potentially hundreds or thousands of unique tracks and connections in a small space. This can make the method physically or economically impractical. The solution is an electronic control system and an interconnect strategy that requires fewer connections. These control systems are available and have been developed for electronic displays over a variety of technologies, not just LED displays.

The technique of multiplexing is relatively well known. The lesser known technique called Charlieplexing, (sometimes referred to as Crossplexing) is also suitable for some LED display systems, but is less straight forward to implement the high speed control and accurate timing functions necessary for the electronics. The advantage of Charlieplexing is that a small number of wiring interconnects are required than multiplexing, the disadvantage is that the polarity of all the diodes is critical to the overall function. The technique does not work with a common n-contact that is naturally found in a semiconductor array fabricated on a single substrate.

It is an object of the present invention to provide an LED emitter that produces an efficient optical focus from a small area LED emitter

It is an object of the invention to provide a method to allow an array of LED on a semiconductor substrate to advantageously use the Charlieplexing electronic control.

**Short Description of the Invention**

The object of the present invention is achieved by a method according to claim 1, a light emitter according to claim 7, the light emitter array according to claim 12, a substrate exposure device according to claim 14 and a display according to claim 15. Preferred embodiments are claimed by the depending claims.

The invention discloses a method of generating an optical structure having a diameter D in a transparent semiconductor substrate, wherein the optical structure has a predetermined peak to peak roughness. The method comprises the steps of ablating the semiconductor substrate by a plurality of laser pulses. A laser pulse creates an ablation pit in the semiconductor surface having a pit centre, a pit diameter and an ablation depth. In one embodiment, the ablation depth of the laser pulses may be smaller than 20 times, preferably smaller than 10 times the predetermined peak to peak roughness.

The optical structure may be a spherical optical structure, such as a spherical lens, a reflector, the body of a parabolic reflector or the like. The substrate may comprise GaAs (Gallium arsenide) and alloys Al or P, GaP (Gallium phosphide) and alloys of Al or In, InP (Indium phosphide) and alloys Ga or In, ZnSe (Zinc selenide), Diamond, Boron Nitride, GaN and alloys of Al or In. These different semiconductor materials allow a broad range of wavelengths from the infrared through the visible range to the UV.

The optical structure may be a passive optical structure.

The laser pulses for ablating the semiconductor surface may be ultrashort laser pulses such as laser pulses shorter than 10 ns. Preferably, the laser pulses are femtosecond laser pulses. In one embodiment the ablation may occur in normal air. The ablation may also be performed at reduced pressure, for example, in a vacuum. In another embodiment the ablation may be carried out in a gaseous environment or a liquid environment in order to better remove the irradiated material possibly by a further chemical reaction.

The spherical optical structure may be paraboloid or partially ellipsoid. In one embodiment the spherical optical structure may comprise a circular diameter D and a convex profile the spherical shape does not define the profile and the profile does not necessarily have a regular or constant radius.

The depth of the ablation pit may preferably range from 50 nm to 500 nm. Typically, the ablation depth is 200 nm. The laser has to be operated such that the depth of the ablation pit may range from 50 nm to 500 nm.

The distance of the centre of adjacent ablation pits is equal to or smaller than the diameter of the ablation pits. This may be achieved by controlling the position of the laser, optics and/or semiconductor substrate such that the distance of the centre of adjacent ablation pits is equal or smaller than the diameter of the ablation pits.

As mentioned before, it is preferred that the diameter of the ablation pits is equal or smaller than 10 $\mu$m, preferably smaller than 5 $\mu$m, more preferred equal and smaller than 2.5 $\mu$m. By the choice of the diameter of the ablation pits and the distance of the centre of adjacent ablation pits the peak to peak roughness of the optical structure may be suitably generated, i.e. reduced.

For ablating the transparent semiconductor substrate surface ultrashort laser pulses being equal to and shorter than 10 ns, preferably shorter than 650 fs may be used.

The sequence of generating the ablation pits on the semi conductor substrate may be selected in a random manner. Thereby, side effects, particularly thermal side effects may be reduced.

The aspect ratio of the diameter of the ablation pit and the depth of the ablation pit is equal or lower than 12, preferably equal or lower than 25. Thereby, a compromise can be found between the peak to peak surface roughness and processing time.

The semiconductor substrate may be ablated in a plurality of layers at the same position of the semiconductor surface. Thereby, structures may be created by ablations that are significantly deeper than the depth of an individual ablation pit.

In one embodiment the semiconductor substrate may be ablated in multiple passes (multiple ablation layers) such that the height of the optical structure is equal or higher than 20 $\mu$m, preferably 50 $\mu$m, more preferred 100 $\mu$m, still more preferred 150 $\mu$m, most preferred 300 $\mu$m, where the thickness of the semiconductor substrate is equal to or less than twice the height of the optical structure, preferred that the optical structure is the same height as the substrate thickness

In another embodiment the semiconductor substrate is ablated in a plurality of ablation layers, wherein the depth of the ablation pits depends on the angle of the optical structure at the respective ablation layer with respect to a horizontal surface of the semiconductor substrate. In other words, the ablation depth is lower, if the desired angle of the optical structure at the respective ablation layer (ablation pass) is low and the ablation depth is higher, if the angle of the optical structure at a given ablation layer (given pass) is higher. Thereby, peak to peak surface roughness and process time may be optimized.

In one embodiment the optical structure may be the spherical structure mentioned before. In order to create a spherical optical structure having a higher height than the ablation depth, the semiconductor substrate may be ablated by a plurality of passes creating a plurality of ablation layers.

The following section describes a method for creating a spherical optical structure having a circular cross-section. As mentioned before, the spherical optical structure includes ellipsoid structures, parabolic structures or any structure having a circular cross-section and a round surface.

A first layer of the transparent semiconductor substrate is ablated by two steps forming a first pass. The first step of the first pass comprises ablating by the plurality of laser pulses a first initial ring having a first ablation depth (h), wherein said first initial ring has a first initial diameter (d11). The second step of the first pass comprises ablating by the plurality of laser pulses a plurality n-1 of first consecutive rings having the first ablation depth (h) and having a first consecutive diameter (d1x) that is successively increased starting from the first initial diameter (d11), wherein in the first consecutive diameter is increased after ablating each first consecutive ring until the first consecutive diameter corresponds to at least and preferably greater than the diameter (D) of the spherical optical structure.

In a second pass a second layer is ablated by the following two steps. The first step of the second pass comprises ablating by the plurality of laser pulses a second initial ring having a second total ablation depth (2 h) being two times higher than the first ablation depth, wherein said second initial ring has a second initial diameter (d21) being larger than the first initial diameter (d11). The second step of the second pass comprises ablating by the plurality of laser pulses a plurality n-1 of second consecutive rings having the second total ablation depth (2 h) and a second consecutive diameter (d2x) that is successively increased starting from the second initial diameter (d21), wherein in the second consecutive diameter (d2x) is increased after ablating each second consecutive ring until the second consecutive diameter corresponds to at least and preferably greater than the diameter (D) of the spherical optical structure.

In further passes m a further layer is ablated by the following steps until the set total ablation depth has been reached. The first step of the further passes comprises ablating by the plurality of laser pulses a further initial ring having a further total ablation depth (m h), wherein said further initial ring has a further initial diameter (dm1) being larger than the second initial diameter (d12) and being larger than the preceding further initial diameter (dm-1,1). The second step of the further passes comprises ablating by the plurality of laser pulses a plurality of further consecutive rings having the further total ablation depth (x h) and a further consecutive diameter that is successively increased starting from the further initial diameter, wherein in the further consecutive diameter is increased after ablating each further consecutive ring until the further consecutive diameter corresponds to at least and preferably greater than the diameter (D) of the spherical optical structure.

The passes described before may be used to manufacturing a concave structure. The method may also be used for manufacturing a concave opening. For manufacturing a concave opening the diameter, within the semiconductor is ablated is reduced for each consequent pass.

The invention also discloses a method of manufacturing a LED element. The method comprises the step of manufacturing at least one emitting region of at least one LED structure on the first side of a transparent semiconductor substrate;. This may be achieved a step of growing an epitaxial layer, typically by a p epitaxial layer on a portion of a n substrate, as is known in the prior art.

The method further comprises the step of generating an optical structure on the second side of the transparent substrate. The second side is on the opposite side of the first side of the transparent substrate In one embodiment the optical structure may be manufactured by the method described before.

In another embodiment the method comprises the step of manufacturing a plurality of LED structures on the first side of a transparent semiconductor substrate as an array of LED elements, wherein each LED element comprises at least one LED structure. The method further comprises the step of generating a plurality of optical structures on the second side of the transparent substrate. The second side is on the opposite side of the first side of the transparent substrate, wherein one optical structure is generated opposite of one LED structure. The array is separated into a plurality of electrically isolated LED elements and/or LED elements arranged in rows. In one embodiment the optical structures may be manufactured by the method described before.

The invention also discloses the light emitter comprising a transparent semiconductor substrate, an epitaxial layer formed on a first side of the transparent semiconductor device and a convex optical structure formed on a second side of the substrate opposite to the epitaxial layer of the light emitting diode. The convex optical structure is adapted to reflect light passing through the substrate. The light emitted from the light emitting diode passes through the substrate, is reflected by the convex optical structure, passes again through the transparent semiconductor substrate and is emitted by the first side of the substrate.

The convex optical structure may be spherical, ellipsoid or parabolic. The emitter of the light emitting diode is arranged opposite the centre of the convex optical structure.

The light emitted by the light emitting diode is reflected such by the convex optical structure that the light impinges after passing through the transparent optical substrate such on the surface at the first side of the transparent optical substrate that the angle of incidence is smaller than the critical angle that results in transmission and not internal reflection.

Since the light emitting diode is not a point source the convex optical structure will not perfectly focus the light emitted by the light emitting diode. The convex optical structure is collimating the light emitted by the light emitting diode with a diameter D similar to the diameter of the convex optical structure, when the light exits at the first side of the semiconductor surface. The convex optical structure has to reflect the light beams emitted by the light emitting diode such that all angles, including converging or diverging angles, are below the critical angle, such that there is very little internal reflection in the transparent semiconductor surface to avoid crosstalk, if the light emitters are arranged in an array. Further, all light emitted by the LED must be reflected by the convex optical structure (optical mirror). This may be achieved by reducing the height of substrate between the LED and the convex optical structure by increasing the total ablation depth or reducing the design height. In a preferred embodiment the height of the convex optical structure is increased to the height of the substrate.

The transparent optical substrate may comprise GaAs (Gallium arsenide) and alloys Al or P, GaP (Gallium phosphide) and alloys of Al or In, InP (Indium phosphide) and alloys Ga or In, ZnSe (Zinc selenide), Diamond, Boron Nitride, GaN and alloys of Al or In. These different semiconductor materials allow a broad range of wavelengths from the infrared through the visible range to the UV.

The convex optical structure may be at least partially coated with a reflecting layer, a metallic layer, a multilayer dielectric coating layer and/or a dielectric layer. On the convex optical structure a single layer or a plurality of layers may be deposited. For example, a first layer coating the convex optical structure may have good reflective properties. Such layer may be a metallic layer.

The reflecting layer may comprise aluminium or silver. In one embodiment the reflecting layer may comprise a single metal layer or multiple metal layers with an initial seed layer of titanium or chrome, as is known to the person skilled in the art. In another embodiment the reflecting layer may comprise a zinc and silver metal layers. Alternatively, the reflecting layer may also be an electrical contact to the transparent semiconductor, comprise titanium-silver or a chromium-silver layers. The electrically conducting layer (metallic layer) may comprise a titanium-aluminium alloy, a silver-zinc alloy, a titanium-silver alloy and/or a chromium-silver alloy.

The dielectric layer may be formed as part of a process to decrease the surface roughness (peak to peak roughness) caused by the choice of ablation diameter and distance from centre to centre of neighbouring ablation pits.

In a further embodiment, a reflecting layer is formed on the first side of the transparent semiconductor substrate. The reflecting layer may be a contact for one layer of the LED, such as the p-layer of the LED. Preferably, the reflecting layer may be the electric contact for the p-layer. The reflecting layer is only formed on a part of the first side, namely to contact one layer of the LED. The reflecting layer may be a metal layer. If the p-contact is transparent, such as an ITO contact, a reflecting layer can be formed on the p-contact. Also in this embodiment the reflecting layer may be formed of metal. Thereby, more light can be directed into the concave optical structure. Where the reflecting layer is used for forming a conducting track to the contact of the LED, it should be formed such that the width is as small as possible in order to minimize losses, particularly the width must be as small as possible in an area in which light is exiting the semiconductor surface.

The first side of the substrate may be formed concave around the LED of the light emitting diode. The light emitting diode may be formed in the centre of the concave structure. The concave structure may act as an additional lens for collimating, diverging and converging light reflected from the convex optical structure. The concave optical structure may be formed by laser ablation as described before. After laser ablation a polishing step may be carried out prior to the formation of the LED.

At the first side of the transparent semiconductor structure a concave transparent structure may be formed. The concave transparent structure may be adapted to diverge or converge light reflected by the convex optical structure and exiting from the transparent semiconductor device. The centre of the concave transparent structure may be below the centre of the emitter and the centre of the convex optical structure. The concave optical structure may collimate, diverge or converge the light beams reflected by the convex optical structure.

The invention also discloses a light emitter array comprising a plurality of light emitters, wherein the light emitters are arranged in rows and columns. The light emitter array further comprises a plurality of row connectors, wherein each row connector is coupled to all light emitters of one row of the array. A row connector may be directly connected to the transparent semiconductor surface, such as on the first side of the transparent semiconductor surface.

The present invention discloses in one aspect a design that produces an efficient optical focus from a small area LED emitter. It overcomes two significant disadvantages of LED sources to produce an optical focus, efficient use of the generated light and high extraction efficiency. The design uses integrated optics fabricated in the semiconductor substrate, as well two reflectors on the substrate surfaces. The design overcomes the major losses that occur when the light generated from a small area LED emitter propagates into the substrate in all direction, and controls the exit angle from the high refractive index material to air to minimise losses.

Light is generated from a small area source on one side of the LED substrate. On the opposite surface of the substrate to the source, a mirrored profiled surface is fabricated. The sag of the mirror is large compared to the diameter of the source, and is also a significant proportion of the LED substrate thickness, only limited by the mechanical handling. The light generated from the source is emitted in all directions, propagating through the substrate towards the mirrored surface and is reflected by this mirrored surface and directed back towards the surface containing the source.

The light therefore propagates for a second time through the LED substrate. The light that is reflected back from the mirrored surface is travelling in a direction almost perpendicular to the substrate surface, less than the critical angle for transmission and not reflection to occur at this surface. This allows almost all of the reflected light to exit the substrate on the source side.

The design of the mirrored surface profile can be varied during the fabrication process so that the light can be brought out perpendicular to the substrate surface, converge to a focus external from the LED substrate, or diverge at a controlled angle. As most of the light is transmitted at the substrate surface and not reflected internally, most of the light generated by the source and reflected by the mirrored surface exits the substrate. This creates a design that is highly efficient.

In a further modification of the source, the contact electrode can be fabricated to be preferably reflecting, not transmitting. In this case, more of the generated light can be reflected towards the mirrored surface, without first exiting the substrate. This creates a design where near 100% of the generated light can be directed towards the mirrored surface, not just 50% with a transmitting electrode.

With this dual mirror design, a very high percentage of the generated light can be extracted from the substrate. For such an efficient system, the emitter area can be further reduced to be nearer a point source while still generating a significant optical flux. This is advantageous to produce a small focus waist of the generated light.

The light emitter described above comprises one cell of a 2D array of cells as described below. Each cell comprises an emitter region formed by the LED that emits light when powered.

The light emitter array may further comprise a plurality of column conductors, wherein each of the column conductors is connected to at least one light emitter of a first column and at least one light emitter of the second column. Not necessarily all column connectors must be connected to two columns. At least one column connector may be connected to only one column. The column conductors may connect the light emitter on the second side of the transparent semiconductor. Each column connector is coupled to at least one light emitter and one row connector in a different row. Each column conductor may be connected to a plurality of p-contacts of the emitters. Within the transparent semiconductor surface a via may be provided in the substrate for connecting the column connector with one of the row connectors.

The row connector may comprise a metal layer that is used to form the contact as large as possible to achieve uniform current distributions in the bulk material of the transparent semiconductor, a good thermal conduction therein and further provides reflecting properties in a simple planar process.

If the light emitter array comprises n rows of light emitters and m column of light emitters, n+1 column conductors may be provided. The column connector i may be connected to n + 1 - i light emitters of the first column and i - 1 light emitters of the second column. Thereby, the so called Charlieplexing may be achieved by a comparably small effort.

Each column connector is also connected to one of the row connectors of the second side in a position that is not connected to the emitters on the first side, such as by a via.

The in one aspect the present invention is a method of fabricating an array of diodes in a single LED substrate that uses the semiconductor substrate as an electrical feedthrough for p-contacts in adjacent rows and as an electrical contact for the n-contact in the same row. The starting point is an array of diodes in rows and columns. At this point, all the diodes have a common n-contact through the substrate. The rows are at some point in the fabrication sequence isolated from each other. At this point, the diodes in the same row have a common n-contact, none of the p-contacts are connected. Using a window in the p-layer of the first row, an electrical contact is made to the n substrate, as would be found in any lateral LED device. This electrical contact is also made to each of the p-contacts in the adjacent rows or the same column; similarly for the other rows.

The invention allows a significant reduction in the number of electrical contacts to the PCB. For a 10 x 10 array only 11 contacts are needed, not 100. This is a reduction of a factor of ~10X.

The result is a LED array that can be mounted onto a PCB as a surface mount device with large electrode areas to the PCB without intensive metal tracking on the LED substrate.

With this invention a LED array can be simply mounted onto a PCB with the large contact pads of the row connectors. This results in high reliability, low contact resistance and low thermal resistance.

The invention also discloses a substrate exposure apparatus, comprising the above light emitter array and a substrate holding device, adapted to hold a substrate. The substrate may be a printed circuit board, a ceramic substrate or a semiconductor substrate that comprises a comparably low level of integration. The substrate holding device is arranged such that light emitted from the light emitters of the light emitter array impinges on the substrate held by the substrate holding device. The substrate may be coated with a photo resist layer. Thus, the substrate exposure apparatus may be controlled such to structurally expose the photo resist layer deposited on the substrate for manufacturing structures thereon, such as contacting tracks.

The concave optical structures and/or the convex optical structures of the light emitters of the light emitter array may be adapted such that light beams emitted by the LED cell are collimated and/or converged. Thereby, the spot size of the illuminated spot by the light emitters may be clearly defined and controlled.

The invention also discloses a display apparatus having the light emitter array described above. The display apparatus may display information, such as text, images and/or videos. The convex optical structure and/or the concave optical structure of the light emitters of the light emitter array of the display apparatus may be formed such that light emitted by each LED cell is diverging, when it exits the light emitter. Thereby, the information displayed by the display apparatus is visible for the user under a wider range of angles.

The invention is now described in more detail under reference to the accompanying drawings showing preferred and not limiting embodiments of the present invention, wherein:

Figure 1 shows a cross section of a first embodiment of the LED element according to the present invention;

Figures 2 shows a cross section of a second embodiment of the LED element according to the present invention;

Figures 3 show a cross section of a third embodiment of the LED element according to the present invention;

Figure 4 shows a cross section of forth embodiment of the LED element according to the present invention;

Figure 5 shows a perspective view of an array of light emitters according to the present invention

Figures 6a to 6c show exemplary beams emitted by the light emitter according to the present invention;

Figures 7a to 7c show exemplary beams emitted by the light emitter according to the present invention;

Figure 8 shows a schematic preferred for Charlieplexing;

Figure 9 shows a prior art arrangement of an array of LED emitters on a substrate;

Figure 10 shows an arrangement of an array of LED emitters on a substrate according to the present invention;

Figure 11 depicts an approach for n-contacts of LED emitters on a substrate according to the present invention;

Figure 12 depicts an approach for p-contacts of LED emitters on a substrate according to the present invention;

Figure 13 shows a layout of column connectors and row connectors;

Figure 14 shows a single lens;

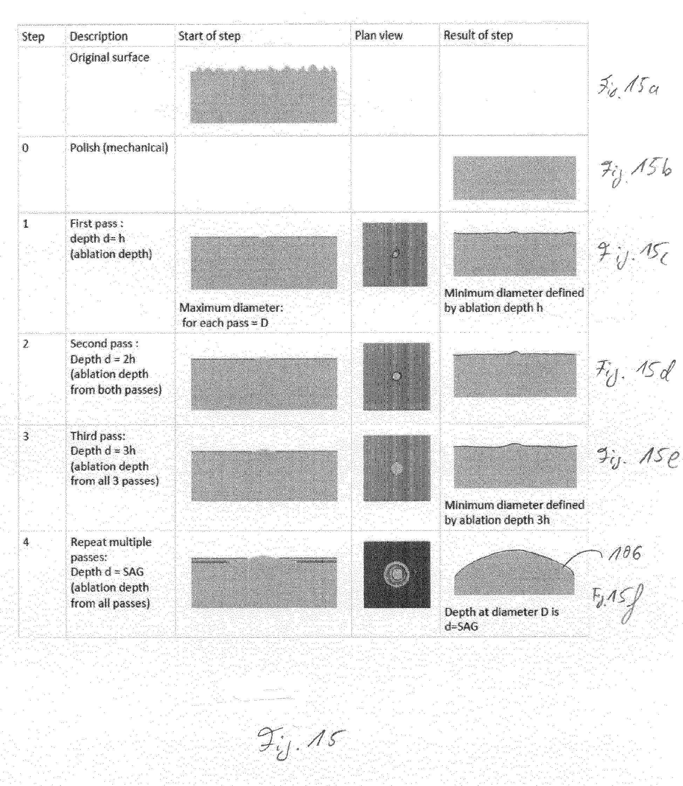

Figure 15 shows steps for fabricating the convex profile;

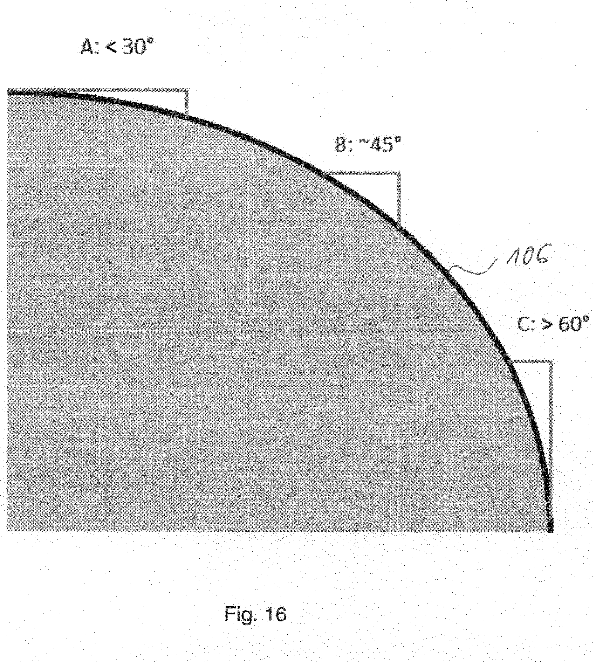

Figure 16 shows a variable ablation depth;

Figure 17 depicts a section though a column of light emitter; and

Figure 18a to 18e show optical properties of the light emitter according to the present invention and a prior art light emitter.

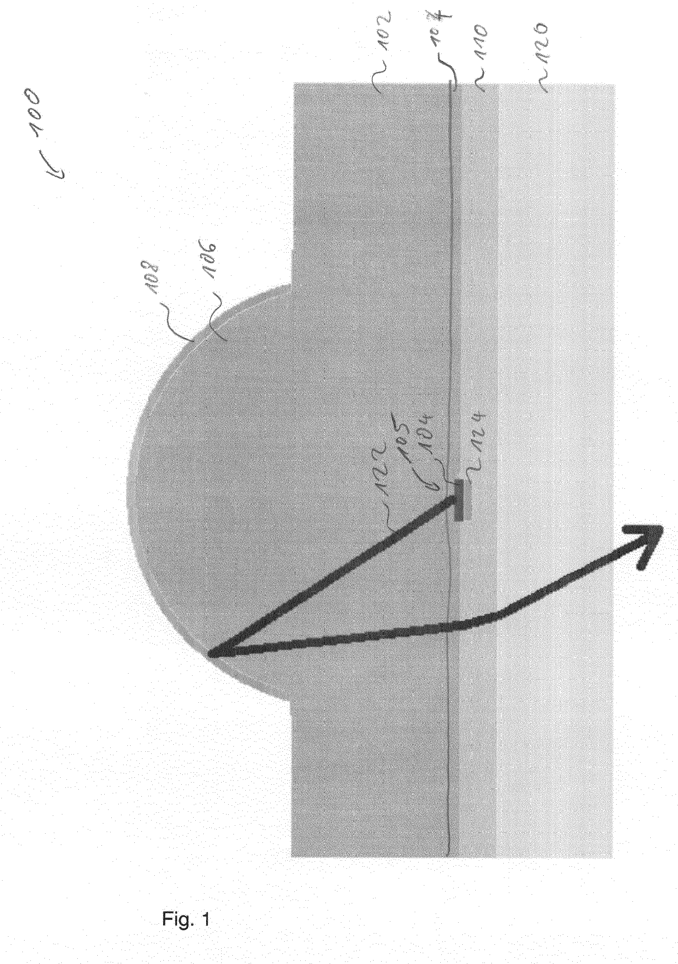

The first aspect of the invention is explained with reference to Figures 1 to 4 showing cross sections through a light emitter 100 according to the present invention. In an n semiconductor substrate 102 a p region 104 is generated by epitaxial growth for forming a light emitting diode 105 with is actually the active region generating the light emission. The substrate may comprise GaAs (Gallium arsenide) and alloys Al or P, GaP (Gallium phosphide) and alloys of Al or In, InP (Indium phosphide) and alloys Ga or In, ZnSe (Zinc selenide), Diamond, Boron Nitride, GaN and alloys of Al or In. These different semiconductor materials allow a broad range of wavelengths from the infrared through the visible range to the UV.

The light emitting diode 105, when powered in forward direction, emits light, such as beam 122, propagating through the transparent semiconductor substrate 102. Opposite to the LED 105 a spherical optical structure 106 coated with an optional reflecting layer 108 is arranged. The spherical optical structure 106 may be paraboloid or partially ellipsoid. The light beam 122 is reflected by the spherical optical structure 106 and propagates again through the semiconductor substrate 102.

After exiting the semiconductor substrate 102 the beam enters in a sealant 110 and thereafter in a transparent substrate 112, such as glass. The sealant 110 may act as bond layer. The main sealant may comprise silicone rubber, and my also comprise epoxy or acrylic. The beam 122 is deflected each time it enters a different material.

The inventive light emitter 100 allows that more light of the LED 105 is emitted by the light emitter 100 under a predetermined angle range. Thereby, efficiency is increased.

At the p layer a reflective metal layer 124 for contacting the p layer 104 may be arranged. Thereby, a higher portion of light is directed into the semiconductor surface 102. The reflective layer 124 may be the p contact or a p contact may be arranged between the epitaxial layer and the reflective layer 124.

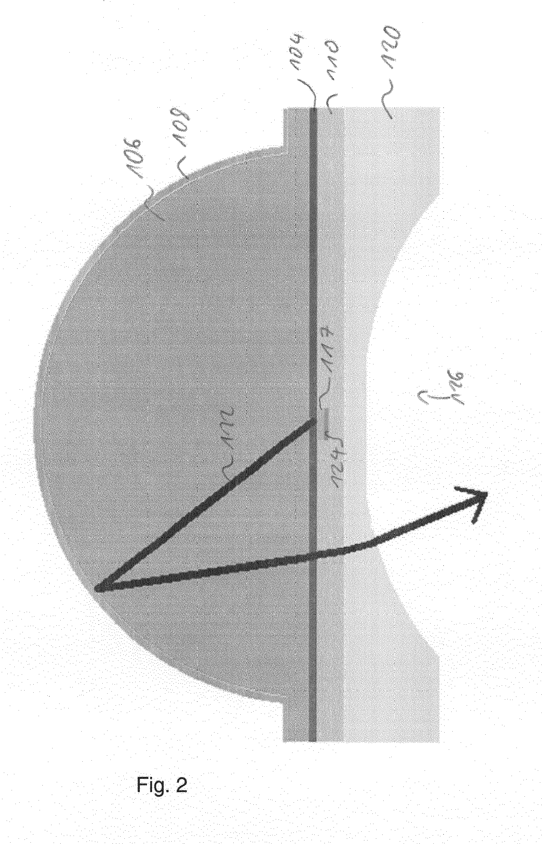

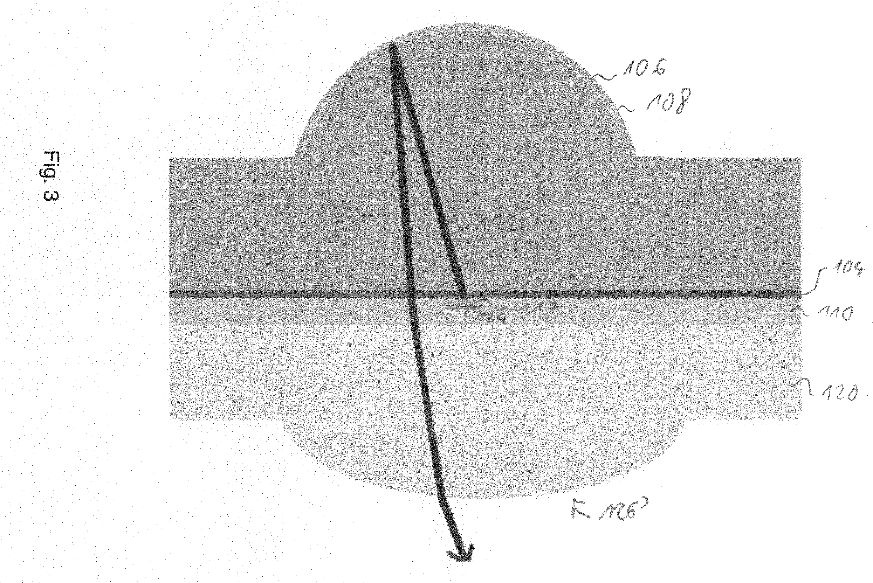

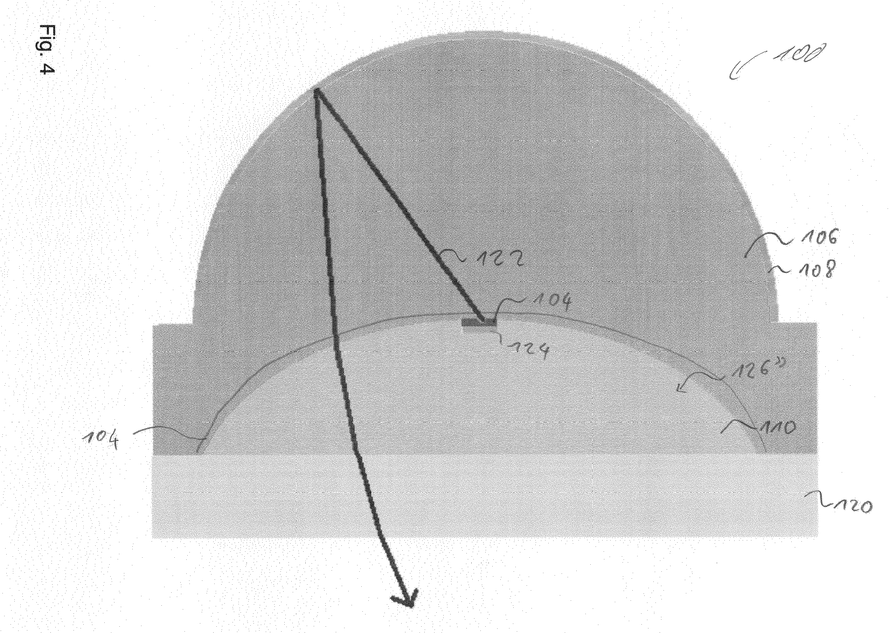

Reference is made to figures 2 and 3 showing a second and third embodiment of the present invention, and figure 4 showing a fourth embodiment of the present invention.

According to figures 2 a concave structure 126 is provided in the transparent substrate acting as a lens. Similarly, in Figure 3 a convex structure 126' is provided in the transparent substrate acting as a lens. The lens may form the beams to a plurality on collimated, diverging or converging beams. A p contact layer is arranged between the p epitaxial layer and the second reflector 124 (metallic conductor).

Figure 4 shows a fourth embodiment in which the concave optical structure 126' is formed in the transparent semiconductor substrate 102. The concave structure 126" is filled with a sealant 110. Next to the transparent semiconductor substrate 102 and the sealant 110 the transparent substrate 120 is arranged. The concave optical structure 126' also deflects the beam 122 like a lens. Thereby, collimating, diverging or converging beams may be achieved.

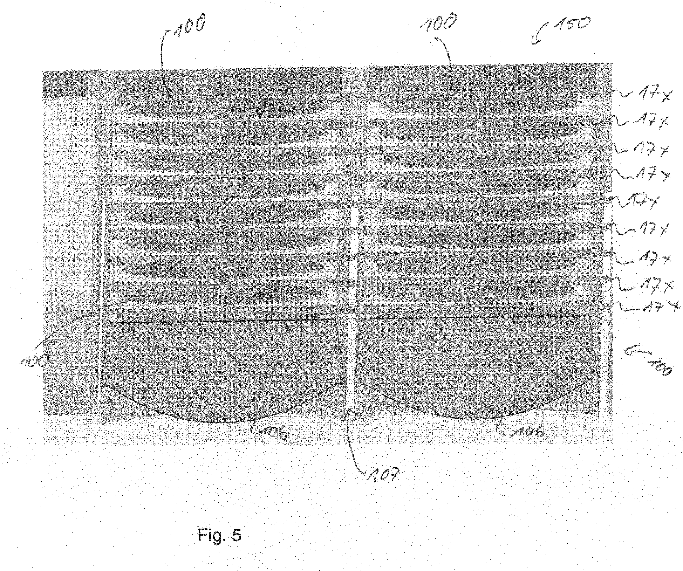

Figure 5 shows a perspective a partially cut away view of a plurality of light emitters 100 arranged in an array 150. The convex optical structures 106 are arranged on the second side of a substrate having a plurality of light emitters 100. The dimensions of the LEDs are approximately or smaller than 10 $\mu$m. The dimension (such as diameter) of one light emitter 100 may be approximately 800 $\mu$m in one embodiment. Generally, the dimension (such as diameter) of one light emitter 100 is dependent on the thickness of the transparent semiconductor substrate 102 and the height of the convex optical structure 106.

The LEDs are connected by a plurality of row connectors 17x which will be described in further detail below. The column connectors 17x are connected by the line 124 with the p-region of the LED 105. The two rows of light emitters 100 of the array are separated and isolated by a gap 107 as described in more detail below.

The first aspect of the invention controls the incident angle of light emitted from an emitting region 105 such that the light efficiently exits through a transmitting surface 120 without further internal reflection. The light is generated by an emission area 105 that is smaller than the exiting emission from the semiconductor substrate 102. The emission passes through the semiconductor substrate 102 twice.

The exit surface from the semiconductor 102 is the same as the emission surface. The emission radiation profile is modified from a uniform distribution to a near collimated or focusing beam, as described below.

The light emitter is composed of at least one primary reflector surface 108 and one transmitting exiting surface 120. Both surfaces can be profiled to affect the exiting radiation pattern.

A second reflector 124 can be advantageously placed over the emitter 105 to reflect light into the semiconductor material 102. The size of this emitter reflector 124 is significantly smaller than the primary reflector 108.

Most of the incident light on the reflector surface is reflected back towards the source 105.

Most of the light incident on the exit surface from the reflector 108 is transmitted. The reflector material can be a metal or a multilayer dielectric coating.

The exit surface may be coated in another transparent material. The surfaces of this transparent material 106 may be shaped to control the radiation profile exiting from the light semiconductor material.

The electrical contact 124 to the emitter 105 acts as a reflector such that light from the emitter is directed into the body of the semiconductor 102. The design of the electrical contact is to maximise the light emitted.

The dimensions of the light unit can be varied. The drawings are not drawn to scale and proportions may be exaggerated.

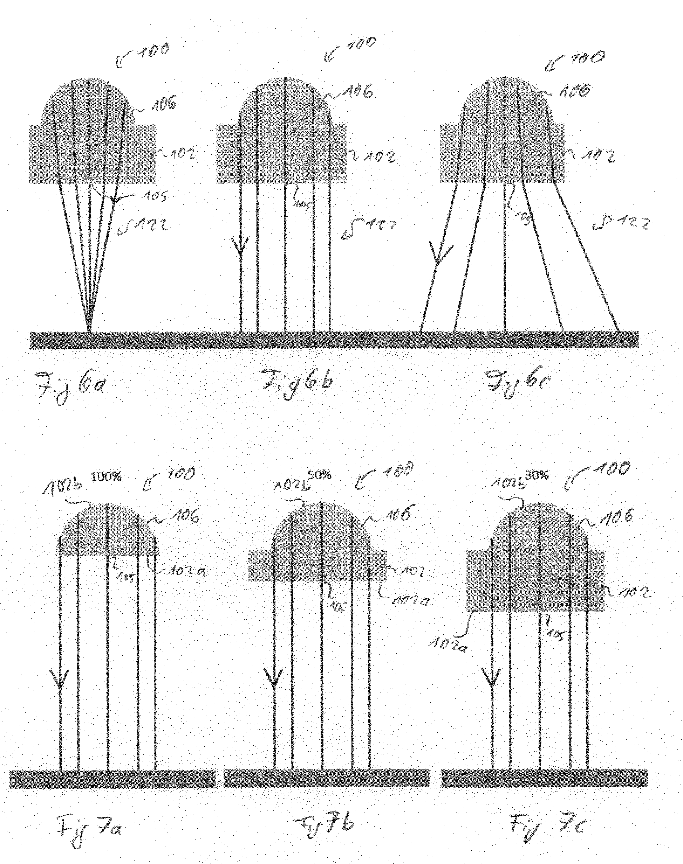

Figures 6A shows a light emitter 100 in which the convex optical structure is structured such that light emitting from the LED generates focused beams 122. This light emitter 100 may be suitable for exposing a resist layer of a printed circuit board. Figure 6B shows a configuration in which the spherical optical structure (concave optical structure) 106 is configured such that light emitted from the LED 105 is collimated and exits the semiconductor substrate 102 as collimated beams. This configuration is also suitable for exposing a resist layer of a printed circuit board by a plurality of light emitters 100.

In figure 6C a configuration as shown in which the light emitted by the source 105 is reflected by the spherical optical structure 106 such that a plurality of diverging beams 122 generated. Such configuration a suitable, if a plurality of light emitters 100 are used for a display device.

Figure 7A shows a configuration in which LED 105 is located at the bottom of the spherical optical structure 106. By this structure losses due to stray are almost eliminated. Figures 7B and 7C show configurations of the light emitter in which the semiconductor substrate 102 comprises different heights. The lower the height of the semiconductor substrate 102, the lower the stray losses and the higher the efficiency of the light emitter 100.

The deeper the profile, more of the generated light is incident on the mirrored second surface 102b, and the efficient of the structure increases. Light generated at the first surface 102a by the LED 105 propagates through the substrate and is reflected form the second surface 102b to the first surface 102a. The smaller the remaining thickness from the first to second surface; the more light is captured by the mirrored second surface and the greater the efficiency of light reflected back to the first surface and emitted from substrate 102.

When the second surface is removed around the mirrored profile, the emitted light is nearly 100% can be reflected out of the substrate 102.

For the light emitter 100 to become active and emit light, electrical contacts must be made to the diode (LED) 105. The advantage here is that the mirrors can also be advantageously used as the electrical contacts 124. No additional electrical contacts to the semiconductor substrate 102 need to be created.

A further challenge is to form the electrical interconnects to an array 150 of such devices. Typically in an LED array 150, the substrate is considered a common electrode. With this approach, only the individual sources need to be connected with external tracking on the substrate to an external PCB or similar. For an array 150 with 100 light emitters 100, this would require 100 tracks to be defined and to have individual electrical contacts from the semiconductor substrate to an external board, in addition to the common substrate contact. This requires significant control of the tracking layout and this can be an limiting influence in the overall fabrication design.

The additional process steps to form an external connection, e.g. wire bonding etc. are all subject to yield and process errors with very large arrays. It also requires that two types of mounting technology are required, surface mount technology for the substrate and ball bonding or wire bonding for the tracking. This can present significant fabrication problems with the combined requirement.

The present invention described in more detail below reduces the number of external connections that need to be made by ~10X. The design also advantageously overcomes the design problems of the contacts on opposite sides of the substrate and eliminates the need for any additional external interconnects to be made or any independent feedthroughs. Only a surface mount approach is required, and for relatively large feature sizes, reducing the risk of connection errors and achieving extremely low contact resistances by using large areas.. This improves the operational efficiency of the devices.

The LEDs 105 can then be driven by external electronic control with simple, large scale contacts that do not require high resolution assembly techniques. This allows the LED array 150 to be mounted as any other SMD component.

The natural design of the LED light emitter 100 is that the contacts are on opposite sides of the substrate 102, and a method to create a feedthrough is typically required. This has been overcome by a combination of the fabrication of the array and the choice of electronic control.

Commonly in display technology a technique known as multiplexing is used. In this invention a technique known as Charlieplexing is employed. Historically, this technique is not extensively used because it is more difficult to implement than other control techniques, e.g. multiplexing.

Multiplexing is only possible where the there are two electrical contacts to each source, Charlieplexing is also not possible with a LED array 150 using a common electrode. This limitation has been overcome by a novel fabrication procedure isolating each row of the array 150 from each other, and each column of the emitter electrical contacts connecting to the electronic control system.

Even with this arrangement, it's simple form only half the array can be fully controlled, that is, only half of the LEDs 105 have separate n and p-contacts. The remainder are shorted across the n and p-contact. The solution to allow full electronic control and simple fabrication is achieved when one half of the array is shifted by one row and one column The location of each LED is mapped in software, so the physical location and electrical connections do not represent a design barrier.

The re-organisation of the LED emitter 100 interconnections also benefits the design as the rows now become the electrical feedthroughs for all contacts. The column connector may use some assembly techniques to make all the contacts (wire bonding, ball bonding etc.). The rows can be bonded with some electrically conducting material directly to the PCB.

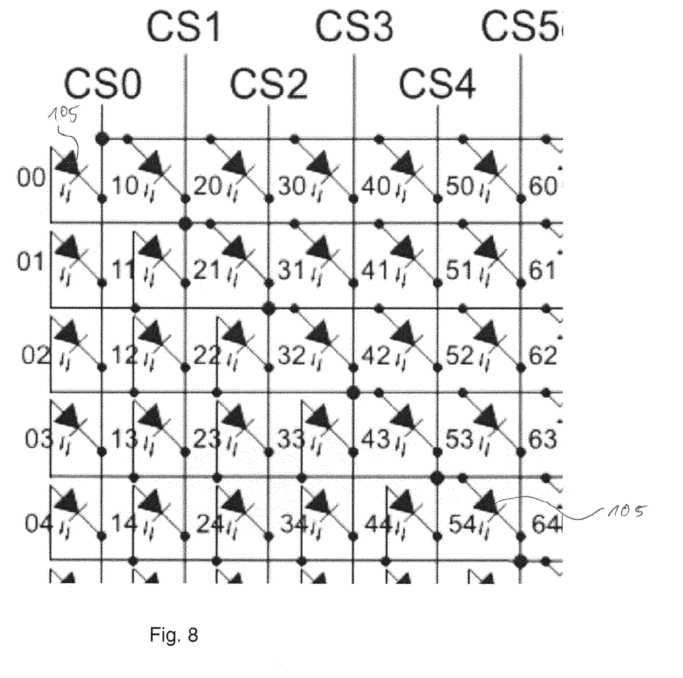

Figure 8 shows a schematic for connecting the array 150 of LEDs105 to a control preferred for Charlieplexing. However, such layout may not be achieved with a common design. It is not possible to link the 'tri-point' intersection because of the common n-electrode (substrate 102).

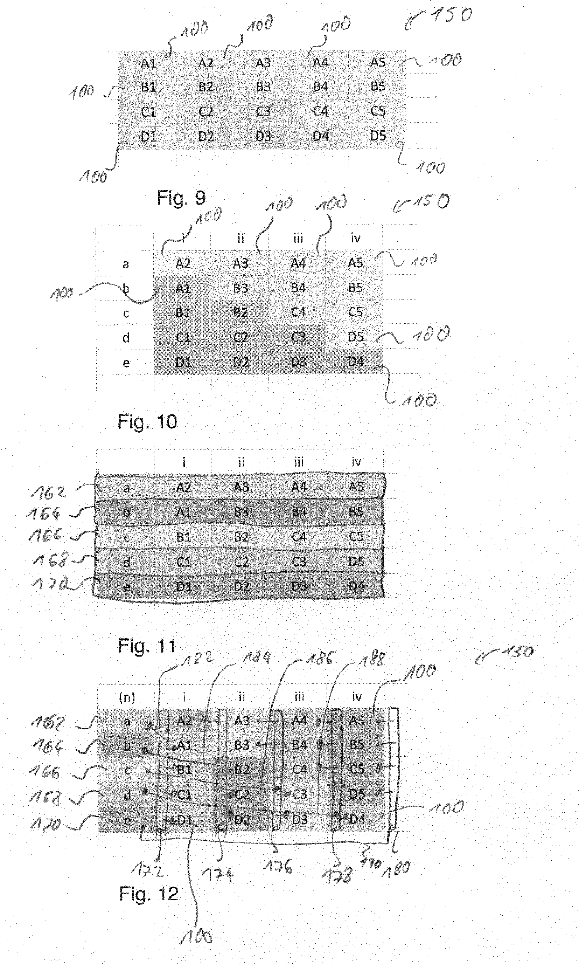

Figure 9 shows a prior art arrangement of an array 150 of LED emitters 100 A1-D5 on a common substrate. In this case, A1, B1, B2 etc. would have a common and negative contact, essentially these LEDs 105 could not have any anodes connected to any cathode as it would be shorted.

Figure 10 an arrangement of an array 150 of LED emitters 100 A1-D5 on a common substrate according to the present invention. The array 150 according to figure 9 is splitted in two arrangements and shifted one half relative to the other. Particularly, one half of the array is shifted one row and one column and forms a new array 150.

Figure 11 shows an arrangement of an array of LED emitters on a substrate according to the present invention. The rows a-e are separated, i.e. isolated from the other rows, such as by a laser, as shown by gap 107 in figure 5. A plurality of row connectors 162-170 are formed connecting all LED emitter 100 of one row of the rows a-e. Preferably, the row connectors 162-170 are connected with the n-substrate 102 of the respective LED emitters 100.

Figure 12 shows the connection of the p -contacts of LED emitters 100 arranged in an array 150 on a substrate according to the present invention. The p-contacts are now split and must be connected to the correct n-row which is used as an electrical feedthrough.

Particularly, the first column connector 172 is connected to the p-contact of the second LED emitter A1, the third LED light emitter B1, the fourth LED light emitter C1 and fifth LED emitter D1 of the first column i. Further, the first rom connector 172 is connected with the first row connector 162 by a first cross connector 182.

The second column connector 174 is connected to the p-contact of the first LED emitter A2 of the first column i and the third LED emitter B2, the fourth LED light emitter C2, the fifth LED light emitter D2 and fifth LED emitter D2 of the second column ii. Further, the second column connector 174 is connected with the second row connector 164 by a second cross connector 184.

The third column connector 176 is connected to the p-contact of the first LED emitter A3 and the second LED emitter B3 of the second column ii and the fourth LED light emitter C3 and the fifth LED emitter D3 of the third column iii. Further, the third column connector 176 is connected with the third row connector 166 by a third cross connector 186.

The fourth column connector 178 is connected to the p-contact of the first LED emitter A4, the second LED emitter B4 and the third LED emitter C4 of the third column iii and the fifth LED emitter D4 of the fourth column iv. Further, the fourth column connector 178 is connected with the fourth row connector 168 by a fourth cross connector 188.

The fifth column connector 180 is connected to the p-contact of the first LED emitter A5, the second LED emitter B5, the third LED emitter C5 and the fourth LED emitter D5 of the fourth column iv. Further, the fifth column connector 180 is connected with the fifth row connector 170 by a fifth cross connector 190.

The unique design is that the substrate has two roles in the electrical circuit. It can act as an electrical n-contact or as a feedthrough for the p-contacts. Either the n or the p-contacts are linked; a common contact. However, each LED 105 has a unique two wire combination, at no time are both the n and the p-contacts operated in parallel. The mapping of the LED emitters 100 has to be changed in the control system.

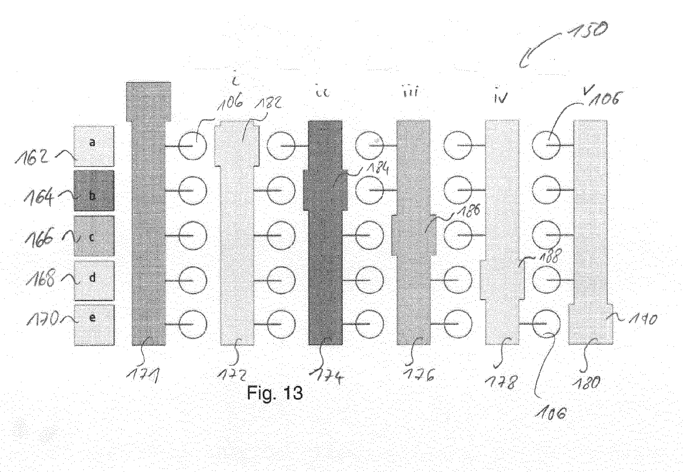

Figure 13 shows a layout of column connectors 172-180 and row connectors 162-170. To visualise the metal interconnects, the cell size has been shown as a rectangular unit cell (2x1) for a 5 x 5 array 150. Reference numeral 106 refers to the convex optical structure 106 of the LED emitters 100. Between the convex optical structures the column connectors 172-180 formed of metal are arranged on the array 150. The column connectors are connected to p-contacts of the respective LEDs105.

The n-contact to each row are connected by the respective row connector 162-170, such as by a via feed through.

On the left of the array is a tracking line 171 with all five p-contacts to the LEDs 105 connected. This is the additional tracking line 171 that connects to an additional region of the substrate, typically the frame of the array. This is unique to all array sizes, that an additional substrate contact feedthrough is required (number of columns + 1). This special case is the only column where all the diodes in one column are connected.

Each of the other vertical column connectors 172-180 is connected to the p-contact of four LEDs 105. This is equivalent to number of columns - 1.

The operation is as follows:

As for the first row a, the electrical contact (cross connect) to the n-substrate is made in the second column (ii). The first column connector links 172 all the diode p-contacts in the first column except the LED on first row (a).

As for the second row b, the electrical contact (cross connect) is made in the third column iii. This row provides the electrical p- contact to the single LED in the first row a and second column ii and the three LEDs in the third, fourth and fifth row c, d, e of the second column ii. This scheme has been described above in more detail.

To illuminate any diode, the correct connections must be made to the n-substrate by rows a-e. For example, when row a is driven +ve, the diode emitters (b,ii), (c,ii), (d,ii) and (e,ii) are +ve at their anodes. When row b is driven -ve; this connects diodes (b, i), (b,ii), (b,iii), (b,iv) and (b,v) a -ve ground; and the emitter (b,ii) will emit light. No other diode will be powered correctly. Other diodes are powered in reverse bias, so no light is emitted.

This invention also discloses a method of forming the convex optical structure according to figures 1 to 7. The method is discussed now with respect to the formation of an optical reflecting profile 106 in a semiconductor substrate 102 fabricated by a pulsed laser ablation process. The method uses an ultrashort laser pulse (<8ns and preferentially < 650 fs) focused to a small diameter on the substrate 102. The substrate 102 may not be at exactly the focus of the laser light, but could also be at a defocused depth to achieve a small critical beam diameter.

The focused laser beam is scanned using polar coordinates to describe circular features. The laser ablation process uses an ablation depth that is preferentially <10X the final desired peak to peak roughness of the optical surface profile (convex optical structure 102).

One challenge was to define a curved surface when the laser can only ablate a vertical wall pit The ablated pit can have a very low aspect ratio; typically a pit depth h=0.2$\mu$m over a pit diameter d=5 $\mu$m, resulting in an aspect ratio of <1:25. The diameter of the focused laser beam is significantly smaller than the diameter D of the lens profile, i.e. convex optical structure. For a polished optical lens surface (reflector surface), the surface roughness is typically <20 nm peak to peak; so an ablation depth <200 nm (0.2μm) is typically required, determined for this method.

The laser is operated during ablation such that an ablation depth is <10X the final desired roughness (peak to peak). a. This is complex because the defined pit is circular and irregular. If an overlap of the pit is too large, the overlap will result in increasing the ablation depth, such as doubling the ablation depth. Too small an overlap and the ablation pits do not overlap and there are regions that are not ablated and remain at the starting surface height (for each pass).

The ratio of the pit diameter to the pitch (coded as beam diameter and spacing) is typically <1 and should be optimised for the profile control. A pitch of the ablated pits (used in the polar scan) should be similar or less than the pit diameter. The surface profile can suffer from periodic structures when the pattern definition is too regular. This has been minimised by introducing a random start position in the laser scanning. The random position is beneficial for surface control within each pass (overall depth of the material removed is more uniform) and from one pass to the next (prevents depth errors from accumulating).

The challenge is to form a deep (eg. 150 μm) profile in the GaN substrate. The method proposes that an ultrashort laser pulse (<8 ns) brought to a focus with a beam diameter of ~5μm to ablate a single shallow (e.g. 200 nm (0.2 μm) or less) pit in defined regions of the material. The laser beam is rastered across the surface using polar (x, ⊖) not cartesian (x, y) coordinates. This is important for circular structures to achieve the correct profile in the substrate. Of course, the method is not limited to circular raster, other patterns are also suitable, including a Cartesian raster pattern.

The control of the ablation depth is important to ensure the correct profile is achieved. The ablation depth is a function of the pulse energy and the spot size on the work piece. If the spot size changes, without a corresponding change in the pulse energy, the ablation depth will change.

During the fabrication of the profile, the spot size is assumed constant. As the substrate material is removed, the position of the focus remains at the original surface level. This results in a defocus of the beam and a corresponding increase in the spot size.

During the ablation of the profile, the position of the focus is changed to ensure the spot size remains constant as the depth into the substrate increases. The depth of focus of the laser, where the difference in spot size has a negligible change, is typically < 50μm. For practical reasons, it is not reasonable to change the depth every pass, but typically the focus is adjusted every 10μm. This method of ensuring constant spot size avoids the need to vary the pulse energy during the process.

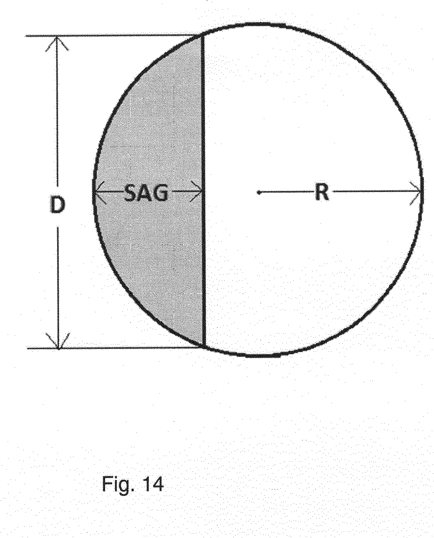

Parameters of a lens or reflector are described with respect to figure 14. For a spherical lens, the maximum depth (SAG) of the lens is defined by the radius (R) of the lens and the diameter (D) where the sphere is cut. The lens shown in figure 14 has a diameter D and the SAG is the thickness of the lens from the vertical line intersecting the sphere to the sphere surface.

The SAG may be calculated according to the following formula:

$$SAG = R - \sqrt{\left(R^2 - \frac{D^2}{4}\right)}$$

The steps for ablating the convex profile 106 are described as follows:

Step 1:

For defining the first pass over the substrate, the minimum scan (ring) diameter Rd = 2*(radius); wherein Rd is the LED emitter diameter or less..The minimum scan diameter may be equal or less the size of the LED emitter 105 and/or the size of the second reflector 124. The circle is scanned 360° to ablate the substrate. In the above equation, SAG = h and D = Rd).

Step 2:

The ring diameter is then increased to the Rd = 2*(radius + distance from pit centre to neighbouring pit centre). A second circle is drawn. This results in an ablated line with a width = 2*distance from pit centre to neighbouring pit centre. This process is repeated until the diameter is equal to the cell size. The result is that a single layer of material has been removed to the ablation depth except for a small central circle defined by the minimum diameter. This completes the first pass.

Step 3:

The second pass has a slightly larger minimum diameter, because the ablation depth is now 2*h. It creates a second step in the surface. The surface will be in the centre at the original surface level (y=0), in some places at y=h and in others at y = 2*h.

Step 4:

Repeat until the chosen SAG is achieved, where SAG = n * h, wherein n is the number of passes. Each pass is defined to start at a position slightly adjacent from the previous pass, an increase defined by the profile geometry, independent of the laser beam diameter. The result of each pass is that there are now steps in the ablated surface that produce the average profile required.

The control of the surface profile is to accurately correspond to a predefined profile defined in the software code driving the process described by the following pseudo code for a spherical lens of radius sphere R:

    for nn = 1 To n Passes

'Calculate the increment to the radius based on the ablation depth h for the first ring

$$indentX = (sphereR\text{\textasciicircum}2 - (sphereR\text{-}( h *nn))\text{\textasciicircum}2)\text{\textasciicircum}0.5$$

'Calculate the number of raster scans per pass (PtoP is the distance from a pit centre to a neighbouring pit centre and radiusMax is the cell size

$$nPocketLines = (radiusMax\text{-}indentX)/PtoP$$

' start to define the ablation raster for a ring radius CircleR
for mm = 1 To n PocketLines

$$circleR = indentX +(PTOP*(mm\text{-}1))$$

Randomise the start point by small angle each time

$$circleXR = RandStartX*circleR$$

$$circleYR = RandStartY*circleR$$

Start the ablation process function
AblatePolar circleXR, circleYR
Next' increment the ring radius mm
Next' increment the ablation depth nn
The next part of the process is to polish the stepped surface to significantly reduce the scattering of the incident light on the refractive surface such that when a metal layer is deposited, the incident is reflected with minimal scattering. The polishing process achieves a surface roughness closer to the desired 20nm peak to peak, by smoothing the steps created by the laser ablation.

The consequent part is to deposit a metal layer that acts as both an high efficiency optical reflector and a low contact resistance electrical conductor. This can be achieved with conventional metal deposition, such as for wiring.

An advantage of the mirror formation is that it also forms the n-GaN electrical contact, as described before. This is important in the electrical interconnect scheme.

In one embodiment the ablation depth of the ablation pit may be variable during the passes, e.g. depend on the angle of the convex structure 106 at the respective pass of ablation.

As the slope of the profile of the convex optical structure 106 changes the geometry of the indent is changed according to the defined profile (dix). Similarly the ablation depth can be varied during the profile definition without adversely affecting the resulting peak to peak roughness. At low angles (case A); the ablation depth needs to be extremely small, relative to the indent in x that defines the first ring dix (across the radius). Where the profile is at or near 45° (case B); the ablation depth and indent in x need to be similar. At large angles (case C); the indent x needs to be extremely small relative to the ablation depth.

The relationship between the equivalent ablation depth as a function of radius has been plotted for the ideal spherical profile. It clearly shows that the ablation depth can be increased depending on the position on the sphere. The actual value of the ablation depth is a function of the desired surface angle. This must be considered when the defined profile is not perfectly spherical.

The increase in the ablation depth could, for example, be achieved by increasing the pulse energy with the same spot size. The spot size could also be changed by defocusing the optics, increasing the area and reducing the fluence. The preferred method is to maintain a constant spot size and change the pulse energy.

The above light emitter array may be used in a photolithography tool for defining patterns in photoresist, eliminating the need to produce glass masks and access sophisticated clean room facilities. The core technology is the light emitter' technology that is used to create arrays of individual LED emitters. The integrated design of the light emitter technology eliminates the need for any external optics. The inherent simplicity of this approach allows the light module to be manufactured using wafer scale assembly techniques, producing small, compact and reliable optical devices. The light emitter array described above is an innovative design of a LED based emitter array with truly integrated GaN optics. The GaN profile has been defined by optical modelling techniques and applied semiconductor fabrication to produce the desired focused spot size.

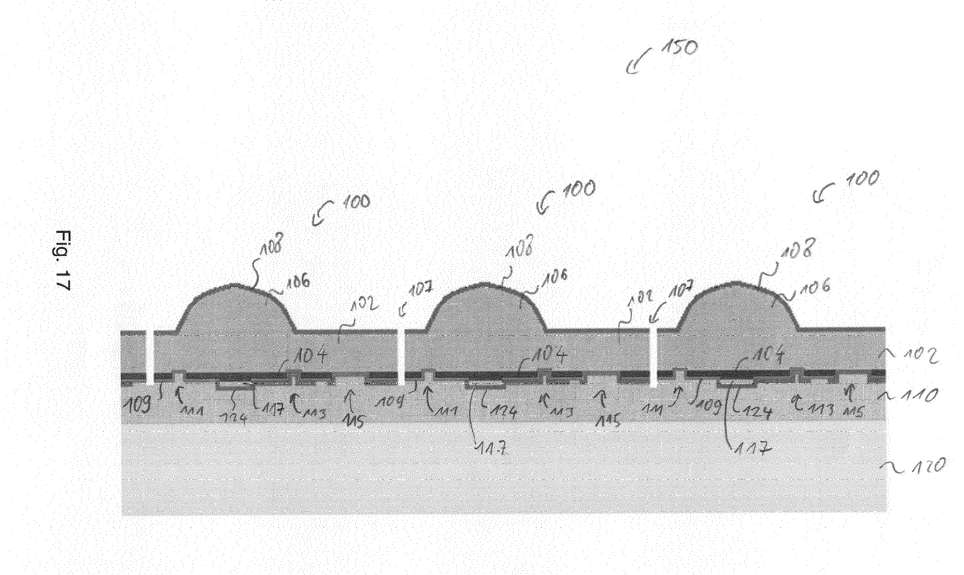

Figure 17 shows a cross section through an array 150 of column of light emitters 100. As described before, a reflecting layer 106 is arranged on the semiconductor substrate 102. The reflecting layer is conductive and also acts as an n-connector for the substrate 102. The epitaxial layer 104 of the LED is connected by the p contact 117 with the metal track 124. Between the track 124 and the epitaxial layer 104 a dielectric layer 106 is acting as an isolator between the track 124 and the epitaxial layer 104, where the epitaxial layer 104 and the track 124 are not connected. On both sides of the epitaxial layer an insulation 111, 115 is provided insulating the epitaxial layers of the LED of the light emitter in the column. On the substrate 102 the sealant 110 and the transparent substrate 120 is provided as mentioned above. Between the light emitter 100 the gap 107 is formed.

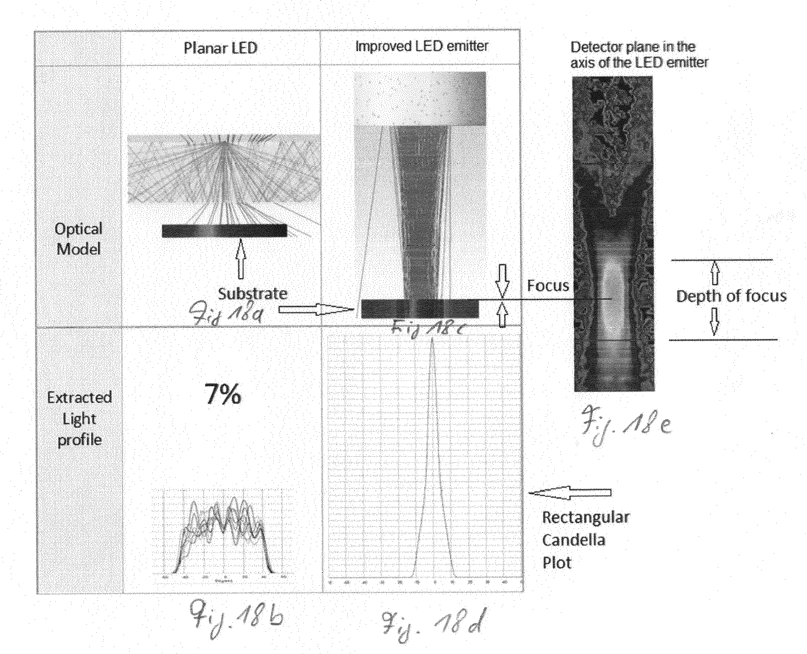

Figures 18a to 18e shown the angle spectrum of the beams generated by the light emitter 100 of the present invention compared to the angle spectrum of the beams generated by a prior art LED. Figure 18a shows a planar prior art LED emitter. Only 7 % of the light generated by the LED emitter impinges on the target substrate under a broad angle rage of - 20° to 20° as shown in figure 18b. Figure 18c shows a LED emitter 100 according to the present invention. Almost all of the light generated by the LED emitter impinges on the target substrate under a narrow angle rage of - 5° to 5° as shown in figure 18d. Figure 18e shows in a candella plot that the light output by the light emitter according to the present invention comprises a comparably wide depth of focus due to the collimated light beams output by the LED emitter according to the present invention.

The emitters are capable of producing more than five times more usable light than the planar technology. This is achieved by redirecting the light internally from the mirrored profile within the critical escape angle for either converging or diverging beams.

The light can be projected by the precise definition of the mirrored profile removing the need for secondary optics to converge the light onto a surface. The lens profile can be altered for each pixel to change the direction of the projected light. It does not have to be a single profile for the whole array. The focus can be changed from converging to diverging to expand the image onto another surface in a controlled way. The light emitters are almost completely optically isolated when the profile is extended deep into the substrate, thus no stray light issues and 'black hole' contrast occurs.

The arrays may be easily soldered as any SMD component. No special assembly processing or equipment required. The highest efficiency device designs operate at a low current density and with very low thermal losses. These factors are major influences in the lifetime of LED devices.

Large area solder contacts eliminate any thermal bottlenecks in the assembly. The unique LED array design eliminates complex tracking requirements allowing the use of standard SMD mounting techniques

The light emitter arrays can be driven from commercially available drivers. The light emitter array may thus be used as a display device.

## Claims

1. A method of generating an optical structure having a diameter D in a transparent semiconductor substrate, wherein the optical structure has a predetermined peak to peak roughness, said method comprising the following step:

- ablating the semiconductor substrate by a plurality of laser pulses, wherein a laser pulse creates an ablation pit in the semiconductor surface having a pit centre, a pit diameter and an ablation depth h, wherein the ablation depth smaller than 20 times, preferably smaller than 10 times, the predetermined peak to peak roughness.

2. The method according to claim 1, wherein the laser is operated such that at least one of the following condition is fulfilled:

- the distance of the centre of adjacent ablation pits is equal or smaller than the diameter of the ablation pits
- the diameter of the ablation pit is equal or smaller than 10 $\mu$m;
- the diameter of the ablation pit is equal or smaller than 5 $\mu$m;
- the diameter of the ablation pit is equal or smaller than 2.5 $\mu$m;
- the depth of the ablation pits may be equal or smaller than 500 nm;
- the depth of the ablation pits may be equal or smaller than 250 nm;
- the aspect ratio of the diameter (dp) of the ablation pit and the depth (h) of the ablation pit is equal or lower than 12, preferably equal or lower than 25.

3. The method of claim 1 or 2, wherein the laser is operated such that at least one of the following condition is fulfilled:

- the semiconductor substrate is ablated in a plurality of layers at the same position of the semiconductor surface;
- the semiconductor substrate is ablated such that the height of the optical structure is equal or higher than 20 $\mu$m;
- the semiconductor substrate is ablated such that the height of the optical structure is equal or higher than 50 $\mu$m;
- the semiconductor substrate is ablated such that the height of the optical structure is equal or higher than 100 $\mu$m;
- the semiconductor substrate is ablated such that the height of the optical structure is equal or higher than 150 $\mu$m;
- the semiconductor substrate is ablated such that the height of the optical structure is equal or higher than 300 $\mu$m;
- the semiconductor substrate is ablated in a plurality of ablation layers, wherein the depth of the ablation pits depends on the desired angle of the optical structure at the respective ablation layer with respect to a horizontal surface of the semiconductor substrate;
- the semiconductor substrate is ablated in a plurality of ablation layers, wherein the distance of the centres of neighbouring ablation pits depends on the desired angle of the optical structure at the respective ablation layer with respect to a horizontal surface of the semiconductor substrate.

4. The method of any one of claims 1 to 3, wherein the optical structure is a spherical optical structure, further comprising the following steps:

- ablating a first layer of the transparent semiconductor substrate by the following two steps forming a first pass:

- ablating by the plurality of laser pulses a first initial ring having a first ablation depth (h), wherein said first initial ring has a first initial diameter (d11); and
- ablating by the plurality of laser pulses a plurality n-1 of first consecutive rings having the first ablation depth (h) and having a first consecutive diameter (d1x) that is successively increased starting from the first initial diameter (d11), wherein in the first consecutive diameter is increased after ablating each first consecutive ring until the first consecutive diameter corresponds at least to the diameter (D) of the spherical optical structure; and

- ablating a second layer of the transparent semiconductor substrate by the following two steps forming a second pass:

- ablating by the plurality of laser pulses a second initial ring having a second total ablation depth (2 h) being two times higher than the first ablation depth, wherein said second initial ring has a second initial diameter (d21) being larger than the first initial diameter (d11); and
- ablating by the plurality of laser pulses a plurality n-1 of second consecutive rings having the second total ablation depth (2 h) and a second consecutive diameter (d2x) that is successively increased starting from the second initial diameter (d21), wherein in the second consecutive diameter (d2x) is increased after ablating each second consecutive ring until the second consecutive diameter corresponds at least to the diameter (D) of the spherical optical structure; and

- ablating further layers of the transparent semiconductor substrate by the following two steps forming further passes m until the set total ablation depth has been reached:

- ablating by the plurality of laser pulses a further initial ring having a further total ablation depth (m h), wherein said further initial ring has a further initial diameter (dm1) being larger than the second initial diameter (d12) and being larger than the preceding further initial diameter(dm-1,1); and
- ablating by the plurality of laser pulses a plurality of further consecutive rings having the further total ablation depth (x h) and a further consecutive diameter that is successively increased starting from the further initial diameter, wherein in the further consecutive diameter is increased after ablating each further consecutive ring until the further consecutive diameter corresponds at least to the diameter (D) of the spherical optical structure.

5. A method of manufacturing a LED element, comprising the following steps:

- manufacturing at least one emitter of at least one LED structure on the first side of a transparent semiconductor substrate; and
- generating an optical structure on the second side of the transparent substrate by the method according to any one of any one of claims 1 to 4 wherein the second side is on the opposite side of the first side of the transparent substrate.

6. The method according to claim 5, further comprising the following steps:

- manufacturing a plurality of LED structures on the first side of a transparent semiconductor substrate as a array of LED elements, wherein each LED element comprises at least one LED structure;
- generating a plurality of optical structures on the second side of the transparent substrate by the method according to any one of any one of claims 1 to 4, wherein the second side is on the opposite side of the first side of the transparent substrate, wherein one optical structure is generated opposite of one LED structure; and
- separating the array into a plurality of electrically isolated LED elements and/or LED elements arranged in rows.

7. A light emitter, comprising:

- a transparent semiconductor substrate;
- a light emitting diode formed on a first side of the transparent semiconductor device; and
- a convex optical structure formed on the second side of the substrate opposite to the light emitting diode, wherein the convex optical structure is adapted to reflect and collimate light passing through the substrate; wherein light emitted from the light emitting diode passes through the substrate, is reflected by the convex optical structure, passes again through the transparent optical substrate and is emitted by the first side of the substrate.

8. The light emitter according to claim 7, wherein the convex optical structure is at least partially coated with at least one of:

- a reflecting layer;
- a metallic layer;
- multilayer dielectric coating layer;
- a dielectric layer.

9. The light emitter according to claim 7 or 8, wherein a reflecting layer is formed on the first side of the transparent semiconductor substrate defining the emitter region of the light emitting diode.

10. The light emitter according to one of claims 6 to 9, wherein at the first side of the transparent semiconductor substrate is formed concave structure around the emitter region of the light emitting diode.

11. The light emitter according to one of claims 6 to 9, wherein at the first side of the transparent semiconductor structure a concave transparent structure is formed, wherein the concave transparent structure is adapted to collimate, diverge or converge light exiting from the transparent semiconductor surface.

12. A light emitter array, comprising

- a plurality of light emitters according to any one of claims 7 to 11, wherein the light emitters are arranged in rows and columns;

- a plurality of row connectors, wherein each row connector is coupled to all light emitters of one row; and
- a plurality of column conductors, wherein each of the column conductor is connected to at least one light emitter of a first column and at least one light emitter of a second column.

13. The light emitter array according to claim 12, wherein, if the light emitter array comprises n rows of light emitters and m columns of light emitters, n+1 column conductors are provided, and wherein the column connector i is connected to (n+1-i) light emitters of the first column and to (i-1) light emitters of the second column.

14. A substrate exposure apparatus, comprising:

- a light emitter array according to any one of claim 12 or 13; and
- a substrate holding device adapted to hold a substrate;

wherein the substrate holding device is arranged such that light emitted from the light emitters of the light emitter array impinge on the substrate held by the substrate holding device.

15. A display apparatus, comprising:

- a light emitter array according to any one of claim 12 or 13.

Fig. 1

Fig. 2

Fig. 3

EP 3 297 044 A1

Fig. 4

Fig. 5

Fig 6a

Fig 6b

Fig 6c

Fig 7a

Fig 7b

Fig 7c

Fig. 8

EP 3 297 044 A1

Fig. 9

Fig. 10

Fig. 11

Fig. 12

24

Fig. 13

Fig. 14

| Step | Description | Start of step | Plan view | Result of step |
|------|-------------|---------------|-----------|----------------|
| | Original surface | | | | *Fig. 15a* |
| 0 | Polish (mechanical) | | | | *Fig. 15b* |
| 1 | First pass : depth d= h (ablation depth) | Maximum diameter: for each pass = D | | Minimum diameter defined by ablation depth h | *Fig. 15c* |
| 2 | Second pass : Depth d = 2h (ablation depth from both passes) | | | | *Fig. 15d* |
| 3 | Third pass: Depth d = 3h (ablation depth from all 3 passes) | | | Minimum diameter defined by ablation depth 3h | *Fig. 15e* |
| 4 | Repeat multiple passes: Depth d = SAG (ablation depth from all passes) | | | Depth at diameter D is d=SAG | *106* *Fig. 15f* |

*Fig. 15*

Fig. 16

Fig. 17

| | Planar LED | Improved LED emitter | Detector plane in the axis of the LED emitter |
|---|---|---|---|
| Optical Model | | | |
| Extracted Light profile | 7% | | |

Substrate

*Fig. 18a*

Focus

Depth of focus

*Fig. 18e*

*Fig. 18c*

Rectangular Candella Plot

*Fig. 18b*

*Fig. 18d*

Europäisches
Patentamt

European
Patent Office

Office européen
des brevets

**EUROPEAN SEARCH REPORT**

Application Number

EP 16 18 9542

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 1 387 413 A2 (MATSUSHITA ELECTRIC WORKS LTD [JP]) 4 February 2004 (2004-02-04) * paragraphs [0021], [0036]; figure 26 * | 1-3,5,6 | INV. H01L33/20 H01L33/46 |
| Y | US 2006/045421 A1 (BAETS ROELAND [BE] ET AL) 2 March 2006 (2006-03-02) * paragraphs [0003] - [0005] * * paragraphs [0042], [0097], [0113], [0139]; figure 5 * | 1-3,5,6 | |
| X<br>Y | US 2015/008392 A1 (BONAR JAMES RONALD [GB] ET AL) 8 January 2015 (2015-01-08) * paragraph [0070]; figure 2 * * paragraph [0084]; figures 7,8 * * paragraph [0010] * | 7,8,12, 14,15<br>13 | |
| X | US 2004/048429 A1 (BAUR JOHANNES [DE] ET AL) 11 March 2004 (2004-03-11) * paragraph [0037]; figure 7 * * paragraph [0054] * | 7-9 | |
| X | GB 1 195 547 A (SIEMENS AG [DE]) 17 June 1970 (1970-06-17) * figure 5 * | 7,8,10, 11 | TECHNICAL FIELDS SEARCHED (IPC)<br>H01L B23K |
| Y | US 4 319 227 A (MALINOWSKI CHRISTOPHER W ET AL) 9 March 1982 (1982-03-09) * figure 5 * | 13 | |

The present search report has been drawn up for all claims

| Place of search | Date of completion of the search | Examiner |
|---|---|---|
| The Hague | 14 June 2017 | Pérennès, Frédéric |

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 16 18 9542

The Search Division considers that the present European patent application does not comply with the
requirements of unity of invention and relates to several inventions or groups of inventions, namely:

1. claims: 1-6

    a method of generating a an optical structure in a
    transparent semiconductor substrate by laser ablation
    wherein a laser pulse creates an ablation pit in the
    semiconductor surface having a pit centre, a pit diameter
    and an ablation depth h, wherein the ablation depth is
    smaller than 20 times, preferably smaller than 10 times, the
    predetermined peak to peak roughness.

    ---

2. claims: 7-15

    a light emitter comprising a convex optical structure formed
    on the second side of the transparent semiconductor
    substrate opposite to the light emitting diode, wherein the
    convex optical structure is adapted to reflect and collimate
    light passing through the substrate and wherein light
    emitted from the light emitting diode passes through the
    substrate, is reflected by the convex optical structure,
    passes again through the transparent optical substrate and
    is emitted by the first side of the substrate.

    ---

## ANNEX TO THE EUROPEAN SEARCH REPORT
## ON EUROPEAN PATENT APPLICATION NO.

EP 16 18 9542

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2017

| Patent document cited in search report | | Publication date | Patent family member(s) | | Publication date |
|---|---|---|---|---|---|
| EP 1387413 | A2 | 04-02-2004 | CN | 1472826 A | 04-02-2004 |
| | | | EP | 1387413 A2 | 04-02-2004 |
| | | | TW | I281268 B | 11-05-2007 |
| | | | US | 2004016936 A1 | 29-01-2004 |
| US 2006045421 | A1 | 02-03-2006 | NONE | | |
| US 2015008392 | A1 | 08-01-2015 | US | 2015008392 A1 | 08-01-2015 |
| | | | US | 2017062654 A1 | 02-03-2017 |
| | | | WO | 2013117944 A1 | 15-08-2013 |
| US 2004048429 | A1 | 11-03-2004 | CN | 1473364 A | 04-02-2004 |
| | | | CN | 1780005 A | 31-05-2006 |
| | | | DE | 10054966 A1 | 16-05-2002 |
| | | | EP | 1332521 A1 | 06-08-2003 |
| | | | JP | 4029034 B2 | 09-01-2008 |
| | | | JP | 2004513519 A | 30-04-2004 |
| | | | TW | 541712 B | 11-07-2003 |
| | | | US | 2004048429 A1 | 11-03-2004 |
| | | | WO | 0237578 A1 | 10-05-2002 |
| GB 1195547 | A | 17-06-1970 | AT | 274914 B | 10-10-1969 |
| | | | CH | 474201 A | 15-06-1969 |
| | | | DE | 1539564 A1 | 11-12-1969 |
| | | | GB | 1195547 A | 17-06-1970 |
| | | | NL | 6710636 A | 10-05-1968 |
| | | | SE | 342383 B | 31-01-1972 |
| US 4319227 | A | 09-03-1982 | CA | 1175526 A | 02-10-1984 |
| | | | DE | 2922595 A1 | 04-12-1980 |
| | | | FR | 2458184 A1 | 26-12-1980 |
| | | | GB | 2052818 A | 28-01-1981 |
| | | | IT | 1131241 B | 18-06-1986 |
| | | | JP | S5623052 A | 04-03-1981 |
| | | | US | 4319227 A | 09-03-1982 |

EPO FORM P0459

For more details about this annex : see Official Journal of the European Patent Office, No. 12/82